Europäisches Patentamt

European Patent Office

Office européen des brevets

(19)

(11) Veröffentlichungsnummer: **0 237 694**
**B1**

(12)

# EUROPÄISCHE PATENTSCHRIFT

(45) Veröffentlichungstag der Patentschrift:
29.11.89

(51) Int. Cl.⁴: **G01R 19/22**, H02H 3/33

(21) Anmeldenummer: **86890036.6**

(22) Anmeldetag: **19.02.86**

(54) Schaltungsanordnung zur Auswertung von von einer Signalquelle gewonnenen Wechselstromsignalen.

(43) Veröffentlichungstag der Anmeldung:
23.09.87 Patentblatt 87/39

(45) Bekanntmachung des Hinweises auf die Patenterteilung:
29.11.89 Patentblatt 89/48

(84) Benannte Vertragsstaaten:
FR GB IT

(56) Entgegenhaltungen:
EP-A- 0 020 080
DE-A- 2 838 716
US-A- 3 546 596

IBM TECHNICAL DISCLOSURE BULLETIN, Band 26,
Nr. 8, Januar 1984, Seite 4091, New York, US; A.G.
BLACK et al.: "OP-AMP full-wave rectifier circuit"

(73) Patentinhaber: **Schrack Elektronik-Aktiengesellschaft**,
**Pottendorferstrasse 25-27, A-1120 Wien(AT)**

(72) Erfinder: **Webley, Philip, Dipl.-Ing.,**
**Hardeggasse 67/8/2/8, A-1220 Wien(AT)**
Erfinder: **Listopad, Manfred, Klimschgasse 2/3/22,**
**A-1030 Wien(AT)**

(74) Vertreter: **Gibler, Ferdinand, Dipl.Ing.Dr.tech.,**
**Dorotheergasse 7/14, A-1010 Wien(AT)**

**Beschreibung**

Die Erfindung bezieht sich auf eine Schaltanordnung zur Auswertung von von einer Signalquelle gewonnenen Wechselstromsignalen, bei der die Signalquelle mit einer zwei Verstärker aufweisenden Verstärkeranordnung verbunden ist, deren Ausgänge miteinander in Verbindung stehen und ausgangsseitig an eine Signalauswerteschaltung, z.B. eine Schwellwertschaltung angeschlossen sind.

Gemäß IBM Technical Disclosure Bulletin, Band 26, Nr. 8, Januar 1984, Seite 4091, New York; A.G. Black, W.G. Hauptman: "OP-AMP Full-wave Rectifier Circuit" bekannte Schaltungsanordnungen besitzen eine Verstärkeranordnung aus zwei jeweils mit einem ohmschen Widerstand negativ rückgekoppelten Differenzverstärkern. Die gegen Masse geschaltete Signalquelle wird an den invertierenden Eingang des einen Differenzverstärkers und an den nicht-invertierenden Eingang des anderen Differenzverstärkers angeschlossen.

Durch die unsymmetrische Verwendung der Differenzverstärker wirken sich jedoch Störeffekte wie Temperaturdrift, Offsetspannungsverschiebung aufgrund HF-Störungen etc. auf das Ausgangssignal der Verstärkeranordnung aus und es bedarf eines erheblichen schaltungstechnischen Aufwandes bei der Auslegung der Verstärker, um solche Effekte unter Kontrolle halten zu können. Weiters erfüllen diese Schaltungen nicht alle Ansprüche an die Übersteuerungssicherheit, thermische Stabilität und Sparsamkeit in der Leistungsaufnahme.

Die Aufgabe der vorliegenden Erfindung besteht daher darin, das Verhalten einer Schaltungsanordnung zur Auswertung von von einer Signalquelle gewonnen Wechselstromsignalen bezüglich der oben erwähnten Größen zu verbessern.

Erfindungsgemäß wird dies dadurch erreicht, daß die Signalquelle mit jeweils einem ihrer beiden Pole mit je einem Verstärker verbunden ist, wobei die Signalquelle an die Eingänge der Verstärker bzw. im Falle von Differenzverstärkern an deren gleichartigen Eingängen angeschlossen ist und die verbleibenden Eingänge der Differenzverstärker an ein Bezugspotential gelegt sind, wobei jeder Verstärker eine durch eine Parallelschaltung eines Widerstandes mit einer Diode gebildete Rückkopplung aufweist und beide Dioden die gleiche Durchlaßrichtung aufweisen.

Durch die symmetrische Verwendung der Differenzverstärker kompensieren sich Störeinflüsse praktisch von selbst, sodaß mit wesentlich einfacher aufgebauten Verstärkern das Auslangen gefunden werden kann. Weiters wird durch die Parallelschaltung eines Widerstandes mit einer Diode im Rückkoppelungszweig eines Differenzverstärkers erreicht, daß nur positive Spannungen gegenüber dem Referenzpotential des Verstärkers an dessen Ausgang auftreten können, wodurch beide Verstärker im linearen Bereich bleiben. Dabei können durch entsprechende Dimensionierungen des Rückkoppelungskreises die Verstärkereingänge sehr niederohmig ausgelegt werden.

Eine bevorzugte Ausbildung der Erfindung besteht darin, daß beide Verstärker mit der gleichen Versorgungsspannung versorgt sind, wobei die Versorgungsspannung den beiden Verstärkern über einen PTC-Widerstand, zu dem noch ein ohmscher Widerstand in Serie geschaltet ist, zugeführt ist, und eine Spannungsbegrenzerschaltung, wie z.B. eine Zenerdiode, parallel zu der Spannungsquelle geschaltet ist.

Durch die gleiche Spannungsversorgung beider Verstärker kann der schaltungstechnische Aufwand in besonders wirksamer Weise minimiert werden und durch Verwendung eines PTC-Widerstandes und einer Spannungsbegrenzerschaltung wird die Leistungsaufnahme der Schaltanordnung bei größeren Betriebsspannungen reduziert und somit auch die thermische Stabilität verbessert. Weiters ergibt sich dadurch auch die Möglichkeit, falls zur Speisung ein Gleichrichter vorgesehen ist, die Schaltung mit einer über einen großen Bereich variierenden Wechselspannung zu betreiben.

Wird die Signalquelle durch eine Spule, z.B. die Sekundärspule eines Wandlers, gebildet und werden die Verstärker über sehr niederohmige Widerstände mit der Spule verbunden, sind die Verstärker zusätzlich gegen verschiedene Störeinflüsse geschützt.

Die Erfindung wird nun an Hand der Zeichnungen näher erläutert. Dabei zeigt:

Fig.1 eine Ausführungsform einer erfindungsgemäßen Schaltung,

Fig.2 eine für die erfindungsgemäße Schaltung verwendbare Signalquelle und Fig. 3 ein Beispiel für die Spannungsversorgung der beiden Verstärker der Schaltung gemäß Fig. 1.

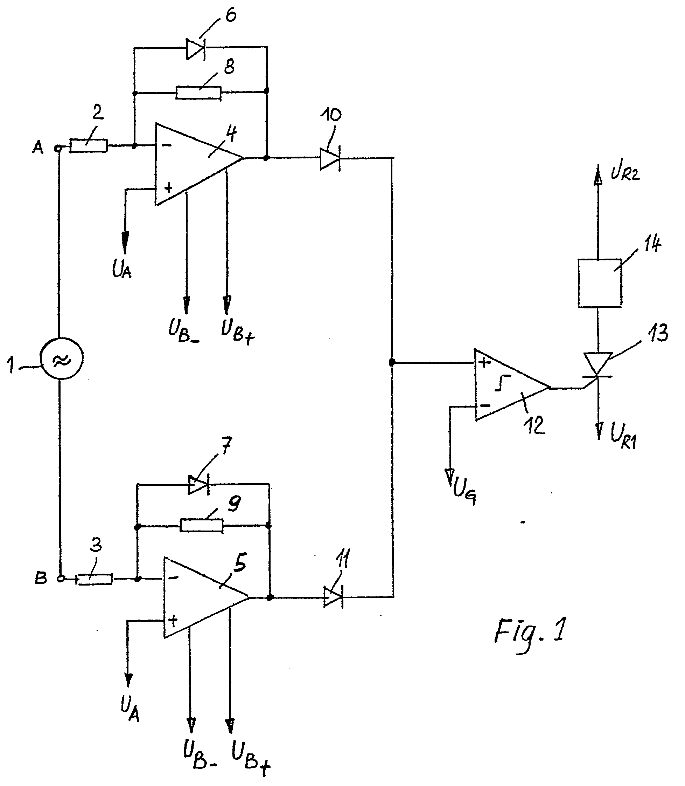

Bei der Ausführungsform gemäß Fig. 1 ist an jeden Ausgang A bzw. B. einer Signalquelle 1 über jeweils einen Widerstand 2 bzw. 3 ein Verstärker 4 bzw. 5 angeschlossen. Diese Widerstände 2, 3 können Teil einer Stoßspannunsschutzschaltung oder einer Funkentstörschaltung und sollen nicht wesentlich größer als der Innenwiderstand der Signalquelle sein. Jeder dieser beiden Verstärker 4,5 ist als ein Operationsverstärker ausgebildet, wobei an den nichtinvertierenden Eingängen der Verstärker 4,5 ein Potential $U_A$ angelegt ist; beide Verstärker sind zweckmäßig mit der gleichen Versorgungspannung $U_{B+}$ und $U_{B-}$ versorgt. Weiters weist jeder Verstärker einen Rückkopplungskreis auf, der aus einer Parallelschaltung aus einer Diode 6 bzw. 7 und einem Widerstand 8 bzw. 9 besteht. Dabei sind die beiden Dioden 6, 7 in den Rückkopplungskreisen in der gleichen Richtung durchlässig.

Die Ausgänge der beiden Verstärker 4, 5 sind über je eine Diode 10 bzw. 11 an einen Eingang einer Signalauswerteschaltung 12 gelegt, die vorliegendenfalls eine Schwellwertschaltung ist. Dadurch wird das jeweils größere Ausgangssignal der beiden Verstärker 4,5 mit der an den zweiten Eingang der Schwellwertschaltung 12 angelegten Referenzspannung $U_G$ verglichen. Diese Schwellwertschaltung steuert einen Thyristor 13, der seinerseits einen Verbraucher 14 steuert, der von einer Spannung $U_{R1}$, $U_{R2}$ versorgt ist.

Die von der Signalquelle kommenden Signale gelangen über die Widerstände 2, 3 zu den Eingängen der Verstärker 5, 6 wobei aufgrund der Dioden 6, 7 in den Rückkopplungskreisen nur gegenüber dem Potential $U_A$ positive Spannungen an den Ausgängen der Verstärker 4, 5 auftreten können, wobei beide Verstärker im linearen Bereich bleiben. Dadurch die Dioden 10, 11 eine direkte Verbindung der beiden Verstärkerausgänge unterbunden ist, gelangt stets das größere Ausgangssignal zu der Schwellwertschaltung 12, die bei einem über der Referenzspannung $U_G$ liegenden Eingangssignal den Thyristor 13 zündet.

Die Ausbildung der erfindungsgemäßen Schaltungsanordnung gestattet es, daß die an den nichtinvertierenden Eingängen der Verstärker 4, 5 anliegende Spannung $U_a$ in vorteilhafterweise nur wenig, z.B. 1,5 - 2V, positiver als das Potential $U_{B-}$ der Versorgungsspannung der Verstärker 4,5 gewählt werden kann. Weiters kann die Referenzspannung $U_G$ nur wenig negativer als das positive Potential $U_{B+}$ der Versorgungsspannung der Verstärker gewählt werden. Auf diese Weise wird die Betriebsspannung $U_{B-}$, $U_{B+}$ der Verstärker optimal genützt wobei die Verstärker 5, 6 nur in jeweils einer Richtung aussteuerbar sein müssen.

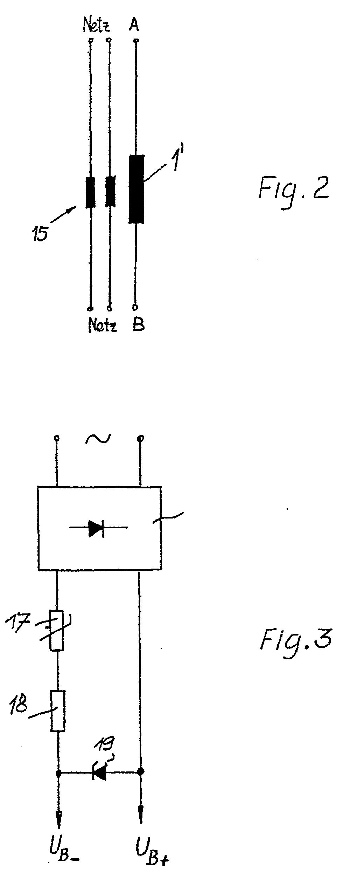

Die Schaltung gemäß Fig. 1 ist besonders für Fehlerstromschutzschalter geeignet, wobei in diesem Falle die Signalquelle 1 durch die Sekundärwicklung 1′ eines Summenstromwandlers 15 gebildet ist, wie dies aus Fig. 2 ersichtlich ist. Dabei wird lediglich die Sekundärwicklung 1′ des Wandlers 15 an die Klemmen A, B, der Schaltung gemäß Fig. 1 angeschlossen.

Die Widerstände 2, 3 sollen in diesem Fall niederohmig sein, d.h. ihre Widerstandswerte sollen nicht wesentlich größer als die Impedanz der Spule 1′ sei.

Für die Spannungsversorgung der Verstärker 5, 6 ist zweckmäßigerweise eine Schaltung gemäß Fig. 3 vorgesehen. Bei dieser ist an einem Gleichrichter 16 eine aus einem PTC-Widerstand 17 und einem Widerstand 18 bestehende Reihensschaltung angeschlossen, wodurch in Verbindung mit einer Spannungsbegrenzerschaltung, vorliegendenfalls einer Zenerdiode 19, die Verstärker 4, 5 über ein Wechselspannungsnetz mit stark unterschiedlicher Spannung versorgt werden können. Dabei ändert sich bei steigender Wechselspannung aufgrund des dadurch bedingten erhöhten Stromflusses über die Zenerdiode Z1 der Widerstandswert des PTC-Widerstandes, wodurch der Stromfluß begrenzt wird und gleichzeitig die Leistungsaufnahme der Widerstände 17, 18 vermindert wird.

## Patentansprüche

1. Schaltungsanordnung zur Auswertung von von einer Signalquelle (1, 1′) gewonnenen Wechselstromsignalen, bei der die Signalquelle mit einer zwei Verstärker (4, 5) aufweisenden Verstärkeranordnung verbunden ist, deren Ausgänge miteinander in Verbindung stehen und ausgangsseitig an eine Signalausweteschaltung, z.B. eine Schwellwertschaltung (12) angeschlossen sind, dadurch gekennzeichnet, daß die Signalquelle (1, 1′) mit jeweils einem ihrer beiden Pole mit je einem Verstärker (4, 5) verbunden ist, wobei die Signalquelle (1, 1′) an die Eingänge der Verstärker (4, 5), bzw. im Falle von Differenzverstärkern an deren jeweils gleichartigen Eingängen angeschlossen ist und die verbleibenden Eingänge der Differenzverstärker an ein Bezugspotential ($U_A$) gelegt sind, wobei jeder Verstärker (4, 5) eine durch eine Parallelschaltung eines Widerstandes (8, 9) mit einer Diode (6, 7) gebildete Rückkopplung aufweist und beide Dioden (6, 7) die gleiche Durchlaßrichtung aufweisen.

2. Schaltungsanordnung nach Anspruch 1, dadurch gekennzeichnet, daß beide Verstärker (4, 5) mit der gleichen Versorgungsspannung ($U_{B-}$, $U_{B+}$) versorgt sind, wobei die Versorgungsspannung den beiden Verstärkern (4, 5) über einen PTC-Widerstand (17, 3), zu dem noch ein ohm'scher Widerstand (18) in Serie geschaltet ist, zugeführt ist, und eine Spannungsbegrenzerschaltung, wie z.B. eine Zenerdiode (19), parallel zu der Spannungsquelle ($U_{B-}$, $U_{B+}$) geschaltet ist.

## Claims

1. Circuit arrangement for evaluating alternating-current signals obtained from a signal source (1, 1′), in which the signal source is connected to an amplifier arrangement having two amplifiers (4, 5), the outputs of which are mutually connected and are connected on the output side to a signal evaluation circuit, for example a threshold value circuit (12), characterized in that in each case one of the two poles of the signal source (1, 1′) is each connected to an amplifier (4, 5), the signal source (1, 1′) being connected to the inputs of the (4, 5), or, in the case of differential amplifiers, to their inputs of the same type in each case, and the remaining inputs of the differential amplifiers being connected to a reference potential ($U_A$), each amplifier (4, 5) having a feedback formed by a parallel connection of a resistor (8, 9) with a diode (6, 7), and both diodes (6, 7) having the same forward direction.

2. Circuit arrangement according to Claim 1, characterized in that both amplifiers (4, 5) are supplied with the same supply voltage ($U_{B-}$, $U_{B+}$), the supply voltage being supplied to the two amplifiers (4, 5) via a PTC resistor (17, 3), to which an ohmic resistor (18) is also connected in series, and a voltage limiter circuit, such as a Zener diode (19) for example, being connected in parallel to the voltage source ($U_{B-}$, $U_{B+}$).

## Revendications

1. Agencement de circuit destiné à l'exploitation de signaux de courant continu obtenus à partir d'une source de signaux (1, 1′), dans lequel cette source de signaux est reliée signaux à un agencement d'amplificateurs comprenant deux amplificateurs (4, 5) dont les sorties communiquent entre elles et qui sont raccordés, du côté sortie, à un circuit d'exploitation de signaux, par exemple un circuit de seuil (12), caractérisé en ce que, par chacun de ses deux pôles, la source de signaux (1,1`) est reliée à un amplificateur (4, 5) pour chaque pôle, cette source de signaux (1, 1`) étant raccordée aux entrées des amplificateurs (4, 5) ou, dans le cas d'amplificateurs, aux entrées de même nature de chacun, les entrées restantes de ces amplificateurs étant mises à un potentiel de référence, ($U_A$), tandis que chaque amplificateur (4, 5) comprend une réaction constituée du montage en parallèle d'une résistance (8, 9) et d'une diode (6, 7) et que les deux diodes (6, 7) possèdent le même sens passant.

2. Agencement de circuit suivant la revendication 1, caractérisé en ce que les deux amplificateurs (4, 5) sont alimentés à l'aide de la même tension d'alimentation ($U_{B-}$, $U_{B+}$), cette tension d'alimentation étant appliquée sur les deux amplificateurs (4, 5) par l'intermédiaire d'une résistance à coefficient positif de témperature (17, 3), sur laquelle est encore branchée en série une résistance ohmique (18), et en ce qu'un circuit limiteur de tension, tel que par exemple une diode Zener (19), est branchée en parallèle sur la source de signaux ($U_{B-}$, $U_{B+}$).

Fig. 1

Netz    A

15    1'

Fig. 2

Netz    B

~

17

18

Fig. 3

19

$U_{B-}$    $U_{B+}$